# EUROPEAN PATENT APPLICATION

(11) **EP 4 852 455 A1**
(43) Date of publication of application: **09.12.2026**
(21) Application number: 24922342.1
(22) Date of filing: 29.01.2024
(51) Int. Cl.: H04R 19/04

(54) **MEMS TRANSDUCER**

(71) Applicant: Nisshinbo Micro Devices Inc., Tokyo 103-8456 (JP)
(72) Inventor: FURUKAWA, Norio, Tokyo, 1038456 (JP); KOUDA, Yoshiyuki, Tokyo, 1038456 (JP); KUROMARU, Yoshimitsu, Tokyo, 1038456 (JP); KOKUBO, Naoya, Tokyo, 1038456 (JP); OZAWA, Kazuaki, Tokyo, 1038456 (JP); MIYAUCHI, Takeru, Tokyo, 1038456 (JP); YAMADA, Keiichi, Tokyo, 1038456 (JP); FUJIMOTO, Yuko, Tokyo, 1038456 (JP); KOMATSU, Daishi, Tokyo, 1038456 (JP); MAEDA, Kiyoshi, Tokyo, 1038456 (JP)
(74) Representative: Stolmár & Partner Patentanwälte PartG mbB
(86) International application number: PCT/JP2024/002641
(87) International publication number: WO 2025/163706

(57) **Abstract**

[Object] The present invention reduces noise that is superimposed on an output signal of a MEMS transducer while avoiding causing problems with mechanical strength of the MEMS transducer.

[Means to Solve] A back plate of a MEMS microphone is configured to include: a plurality of beams arranged concentrically; an outer edge portion surrounding all of the plurality of beams; and a plurality of bridges that connect the outermost beam among the plurality of beams to the outer edge portion and that connect adjacent beams. Further, the acoustic holes defined by the outer edge portion, the plurality of beams, and the plurality of bridges have a substantially quadrangular shape, and all of the acoustic holes have substantially the same opening area.

## Description

### [Field of the Invention]

The present disclosure relates to a MEMS transducer, and particularly to a MEMS transducer having a reduced noise level.

### [Background Technology]

A capacitive transducer has a back plate and a diaphragm disposed opposite each other. The diaphragm comes into contact with a fluid flowing in through an acoustic space (a back chamber, a front chamber, or an air gap) and vibrates in accordance with fluid vibration.
Here, the diaphragm is formed of a conductive film and is biased by a power source such as a charge pump. On the other hand, the back plate has a front surface and a rear surface, the rear surface facing the diaphragm and having a conductive layer formed thereon.
Therefore, for example, when the transducer is placed in the ambient air and air vibration occurs in the ambient air due to audible sound or the like, the diaphragm vibrates in response thereto, and the distance between the diaphragm and the conductive layer of the back plate changes.
A change in capacitance due to the change in distance produces an electrical output signal. That is, the capacitive transducer functions to convert mechanical vibration into an electrical signal. A space between the diaphragm and the back plate (air gap) changes in volume when the diaphragm vibrates.
Therefore, in order to prevent a fluid from being confined in the air gap and restricting movement of the diaphragm, the back plate is provided with a plurality of acoustic holes that penetrate through the front and rear surfaces thereof.

Among capacitive transducers, a transducer that is formed using MEMS (Micro Electro Mechanical Systems) technology is called a MEMS transducer and is widely used in wearable devices, tablets, and other devices as a microphone or an acoustic sensor. It should be noted that the MEMS transducer described in the present disclosure is a capacitive type and does not include piezoelectric types that does not have a back plate.

A MEMS transducer is formed from a semiconductor wafer and has, for example, a substantially cubic outer shape in which one side is less than a few millimeters. Since the back plate and the diaphragm are housed within this minute semiconductor outer shell, both must be formed to be very thin and have delicate structure. That is, the performance is likely to be affected by mechanical strength. In particular, since the mechanical strength of the back plate changes depending on the shape and arrangement of the acoustic holes, various attempts have been made for determining them.
For example, in Patent Document 1, as shown in FIG. 1, acoustic holes 6 provided in the back plate 4 have a circular shape and are formed at predetermined intervals. By forming the acoustic holes in a circular shape in this manner, no corner portions are formed at the edges thereof, and therefore stress concentration can be avoided.

Further, Patent Document 2 discloses, as shown in FIG. 2, that adjacent circular acoustic holes are arranged at 60 degree intervals. Accordingly, the acoustic holes can be arranged more densely.

### [Prior Arts]

### [Patent Documents]

[Patent Document 1] Japanese Unexamined Patent Application Publication No. 2016-002625
[Patent Document 2] Japanese Unexamined Patent Application Publication No. 2011-250169

### [Summary of the Invention]

### [Problems to be Solved by the Invention]

Incidentally, the back plate of a MEMS transducer is constantly exposed to external pressure. In particular, when the MEMS transducer is used as a microphone, an external force acts on the back plate when a loud sound is input to the MEMS transducer and the diaphragm is greatly displaced, or when excessive wind pressure is applied.
At this time, due to the viscous resistance of air, the air that has passed through the acoustic holes may also be affected by flow contraction and transition to turbulence. In such a case, the back plate may undergo displacement or vibration, and furthermore, a small amount of heat may be generated due to friction between the air and the back plate.

Due to the behavior of a fluid such as air passing through the acoustic holes of the back plate as described above, noise may be superimposed on the output signal of the MEMS microphone. Therefore, countermeasures are necessary to prevent such noise from occurring. However, Patent Document 1 and Patent Document 2 described above do not consider such countermeasures against noise.

The technology of the present disclosure has been made in view of the above-described problems, and an object thereof is reducing noise superimposed on the output signal of the MEMS transducer while preventing impairment of the mechanical strength of the MEMS transducer.

### [Means to Solve the Problems]

According to one aspect of the present disclosure, a back plate includes a plurality of beams arranged concentrically, an outer edge portion surrounding all of the plurality of beams, and a plurality of bridges connecting the outermost beam among the plurality of beams to the outer edge portion and connecting adjacent beams.
Further, all of the acoustic holes partitioned by the outer edge portion, the plurality of beams, and the plurality of bridges have a substantially quadrangular shape and substantially the same opening area. Accordingly, the spacing between the acoustic holes can be reduced, and the opening ratio can be improved.
Further, by improving the opening ratio, the external force exerted on the back plate by the fluid can be reduced, and deformation or vibration of the back plate can be reduced, thereby reducing deformation or vibration of the back plate. Furthermore, by arranging the substantially quadrangular acoustic holes at substantially equal pitches in the circumferential direction of the concentric arrangement, stress concentration becomes less likely to occur, and the influence of a decrease in mechanical strength caused by increasing the opening ratio can be avoided.

### [Brief Description of the Drawings]

[FIG. 1] FIG. 1 is a diagram showing a back plate of a conventional MEMS transducer.
[FIG. 2] FIG. 2 is a diagram showing a back plate of a conventional MEMS transducer.
[FIG. 3] FIG. 3 is a diagram showing a cross section of a MEMS transducer according to a first embodiment.
[FIG. 4] FIG. 4 is a diagram showing a back plate of the MEMS transducer according to the first embodiment.
[FIG. 5] FIG. 5 is a diagram showing a back plate of a MEMS transducer according to a second embodiment.
[FIG. 6] FIG. 6 is a diagram showing a back plate of a MEMS transducer according to a third embodiment.
[FIG. 7] FIG. 7 is a diagram showing a back plate of a MEMS transducer according to a fourth embodiment.
[FIG. 8] FIG. 8 is a diagram showing a back plate of a MEMS transducer according to another embodiment.

### [Detailed Description of Embodiments]

Hereinafter, embodiments of the present disclosure will be described with reference to the drawings. In each of the following embodiments, parts that are identical or equivalent to each other are denoted by the same reference numerals.

### (First Embodiment)

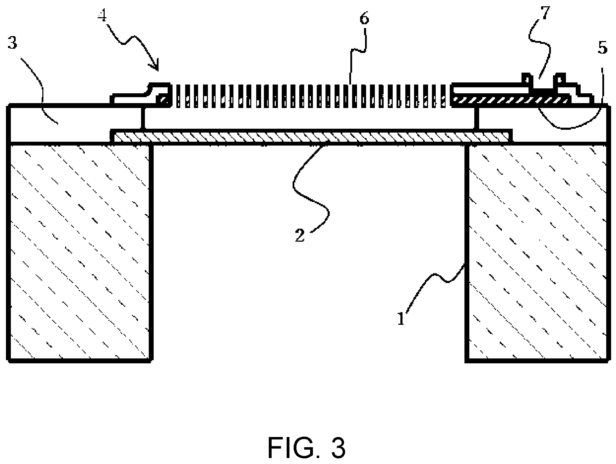

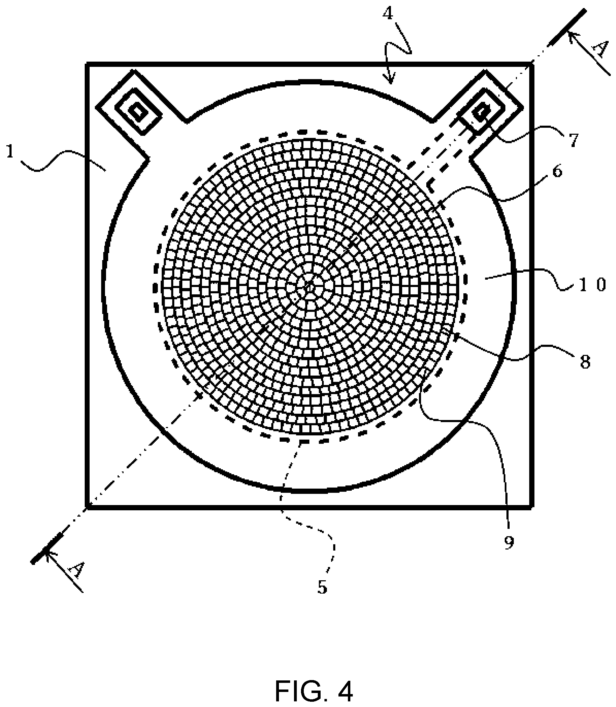

A first embodiment will be described with reference to FIGS. 3 to 4. FIG. 3 shows a cross section of a MEMS transducer, and FIG. 4 shows a plan view of the MEMS transducer, that is, a view as seen from the back plate side. First, the structure of the MEMS transducer according to the present embodiment will be described with reference to the cross section of FIG. 3. The cross section of FIG. 3 shows a view seen from the direction of arrows A-A in FIG. 4.

The MEMS transducer of the present embodiment includes a substrate 1, a diaphragm 2 whose peripheral edge is supported on the substrate 1 via an insulating film 3 (spacer layer), and a back plate 4 arranged in parallel with the diaphragm 2. A rear surface of the back plate 4 faces the diaphragm 2, and a fixed electrode 5 made of a conductive film is formed thereon. Typically, this conductive film is formed of the same material as the diaphragm 2, for example, a doped polysilicon layer, and the conductivity thereof is adjusted by the amount of impurities contained therein.

The diaphragm 2 is biased to a predetermined potential via an electrode (not shown), and the fixed electrode 5 is connected to an electrode 7. Additionally, since the fixed electrode 5 is provided in a region corresponding to at least a part of a region in which the diaphragm 2 can vibrate, the fixed electrode 5 forms a parallel-plate capacitor together with the diaphragm 2. A change in capacitance due to displacement of the diaphragm 2 is output through the electrode 7.

On the other hand, acoustic holes 6 penetrating through the front and rear surfaces are formed in the back plate 4, and a fluid can move through the acoustic holes 6. The fluid is air when the MEMS transducer is placed in the atmosphere and is the predetermined gas when the MEMS transducer is placed in a predetermined gas atmosphere.
Further, as an application in which the MEMS transducer is most frequently used, there is a microphone for picking up sound in the audible frequency band.

Next, the acoustic holes of the back plate according to the present embodiment will be described with reference to FIG. 4.
As shown in FIG. 4, when the back plate 4 is viewed from the surface side, it can be seen that a plurality of substantially quadrangular acoustic holes 6, 6, ... are formed. Here, the term "substantially quadrangular shape" is used because a pair of opposite sides are not straight lines but arcs, and therefore the shape is not geometrically defined as a quadrilateral.
The back plate 4 includes an outer edge portion 10, beams 8, 8, ... arranged concentrically inside the outer edge portion 10, and bridges 9, 9, ... connecting the outer edge portion 10 and the beams 8, 8, ... The bridges 9, 9, ... connect the outer edge portion 10 and the outermost beam 8 (the beam located farthest from the center of the concentric circles) and further connect the beams 8 to each other. Therefore, the acoustic holes 6, 6, ... are regions partitioned by the outer edge portion 10, the beams 8, 8, ... and the bridges 9, 9, .... The widths and numbers of the beams 8, 8, ... and the bridges 9, 9, ... are adjusted so that the acoustic holes 6, 6, ... have substantially the same opening area.
Here, the outer edge portion 10 is a portion of the back plate 4 other than the beams 8, 8, ... and the bridges 9, 9. Further, the fixed electrode 5 is disposed on the rear surface of the back plate 4 and is not visible in a plan view; however, for the sake of understanding the drawing, its extent is indicated by a dotted line in the drawing.

In the present embodiment, the widths of the beams 8, 8, ... and the bridges 9, 9, ... are substantially constant, and the spacing between the outer edge portion 10 and the outermost beam 8 and the spacing between adjacent beams 8 are also substantially constant, and the spacing between adjacent bridges 9 is also substantially constant. As a result, the acoustic holes have a substantially trapezoidal shape near the center and gradually approach a square shape as the distance from the center increases.
In this manner, by appropriately selecting the widths of the beams and the bridges, the spacing therebetween, and the spacing between the outer edge portion and the beams, the acoustic holes can be arranged without leaving unnecessary space.
Further, by making the beams and the bridges thinner, the external force caused by viscous resistance of the fluid passing through the acoustic holes can be reduced, thereby reducing noise. However, if the beams and the bridges become excessively thin, the area of the fixed electrode required for forming the parallel-plate capacitor becomes insufficient, making it difficult to obtain a sufficient output level.
That is, it is important that the ratio of the total area of the acoustic holes 6, 6, ... and the area of the region of the back plate 4 facing the diaphragm 2 (that is, the opening ratio) be set to a predetermined value.
According to experiments and other experience of the inventors, the opening ratio is preferably from 65% to 75%, and 70% was most preferable.

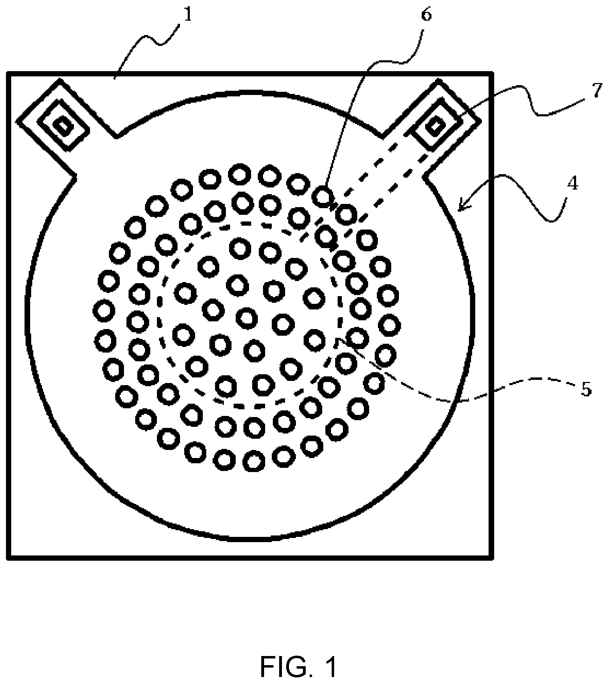

Further, advantages of the MEMS transducer according to the present embodiment as compared with the conventional example will be described.
First, as a first advantage, reduction of influence on the diaphragm will be explained. In the case of the conventional circular acoustic holes as shown in FIG. 1, protrusions remain in a plan view at end surfaces of the spacer layer exposed to the air gap, thereby making the diaphragm more susceptible to damage.
This is because etching of the spacer layer (sacrificial layer etching) is performed by isotropic wet etching in which an etching solution is supplied through the acoustic holes, and therefore the shape of the end surfaces of the spacer layer is influenced by the shape and arrangement of the acoustic holes located at the outermost periphery. The shape of the protrusion becomes narrower toward the tip, and in some cases the tip becomes pointed.
However, in the present embodiment, the acoustic holes at the outermost periphery have a substantially quadrangular shape while the spacing between adjacent acoustic holes is extremely small, and therefore, during sacrificial layer etching, the passage of the etching solution is not obstructed, and protrusions that would damage the diaphragm are not formed.

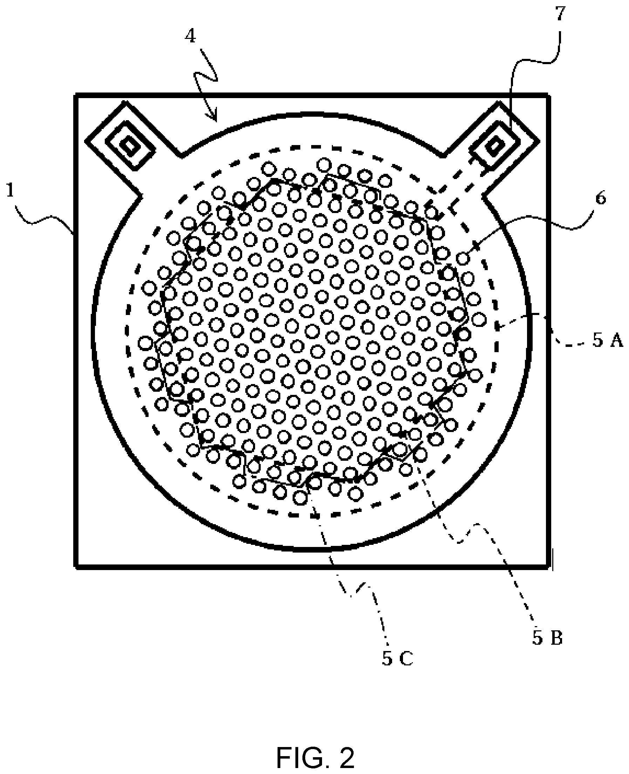

Second, reduction of the influence of stress concentration will be described. As shown in the conventional example of FIG. 2, in an arrangement of adjacent circular acoustic holes arranged at 60 degree intervals (a so-called regular hexagonal arrangement), in order to prevent the edge of the fixed electrode from extending over the acoustic holes, it has been necessary either to make the region of the fixed electrode include all of the acoustic holes 6, 6, ... as indicated by the dotted line denoted by reference numeral 5A in FIG. 2, or to form the fixed electrode in a geometric shape that weaves between the acoustic holes as indicated by the dotted line denoted by reference numeral 5B in the same figure, or to form the fixed electrode in a complex shape as indicated by the chain line denoted by reference numeral 5C in the same figure.
In the region indicated by reference numeral 5A, a bias occurs in the capacitance distribution; in the region indicated by reference numeral 5B, stress concentration occurs at corner portions of the geometric shape; and in the complex shape indicated by reference numeral 5C, although the increase in the number of corner portions results in dispersion of stress, the stress concentration at the corner portions still cannot be avoided.
The stress concentration referred to here is caused by the difference in material between the material of the fixed electrode portion of the back plate and the materials of the beams, the bridges, and other members in contact therewith, and is due to the fact that the mechanical properties differ among these materials.
As described above, a typical material of the fixed electrode is doped polysilicon, and a typical material of portions of the back plate other than the fixed electrode is silicon nitride. These materials differ in rigidity and also differ in thermal expansion coefficients. Therefore, in the case of a fixed electrode having corner portions in its outer shape, delamination at the interface may occur.

In the present embodiment, the outer periphery of the fixed electrode is circular, as indicated by the dotted line 5 in FIG. 4. The circle is concentric with the beams 8, 8, .... Then, the acoustic holes surrounded by the dotted line 5 are substantially uniformly distributed. Therefore, no bias occurs in the capacitance distribution, and since there are no corner portions, stress concentration is also avoided.
Further, the outer shape of the fixed electrode is not limited to this and may be defined in a narrower region. In particular, the fixed electrode may be formed only in portions where the displacement of the diaphragm is large. For example, a conductive layer may be provided on the rear surfaces of all of the beams 8, 8, ... and all of the bridges 9, 9, ..., and these conductive layers may function as the fixed electrode.

### (Second Embodiment)

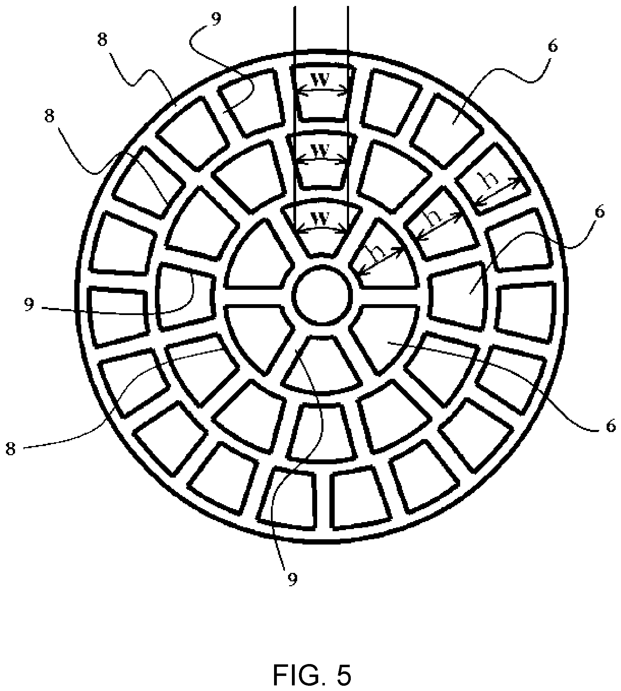

Next, a second embodiment will be described with reference to FIG. 5. FIG. 5 is a schematic view showing the surface of the back plate, in which illustration of the outer edge portion and the bridges connected thereto is omitted. As shown in FIG. 5, the acoustic holes 6, 6, ... are all formed in a substantially trapezoidal shape.

Here, the term "substantially trapezoidal shape" is used because the upper base and the lower base are not straight lines but arcs, and therefore the shape is not geometrically defined as a trapezoid. The upper base of the acoustic hole 6 having the substantially trapezoidal shape is defined by an edge of the beam 8 closer to the center, the two sides extending from both ends of the upper base are defined by edges of adjacent bridges 9, 9, and the lower base is defined by an edge of the beam 8 farther from the center.

The manner of arranging the acoustic holes 6, 6, ... will be described. First, the spacing h between the beams 8, 8, ... is determined, and these beams are arranged concentrically. Next, the bridges 9, 9, ... are arranged so that the width W is approximately the same length. As shown in the figure, this width W is the distance along the circumference between midpoints along the longitudinal direction of the bridges 9, 9. Strictly speaking, since it is not possible to make the width W exactly the same value, the bridges 9, 9, ... are arranged so that the pitch becomes approximately the same while taking into consideration slight increases and decreases. By doing so, the acoustic holes 6, 6, ... are arranged at approximately equal pitches, and their opening areas become substantially the same.

In the present embodiment, since the acoustic holes 6, 6, ... have a substantially trapezoidal shape, the spacing between the acoustic holes can be reduced as compared with shapes having right-angled corners such as squares, and the opening ratio can be increased.

### (Third Embodiment)

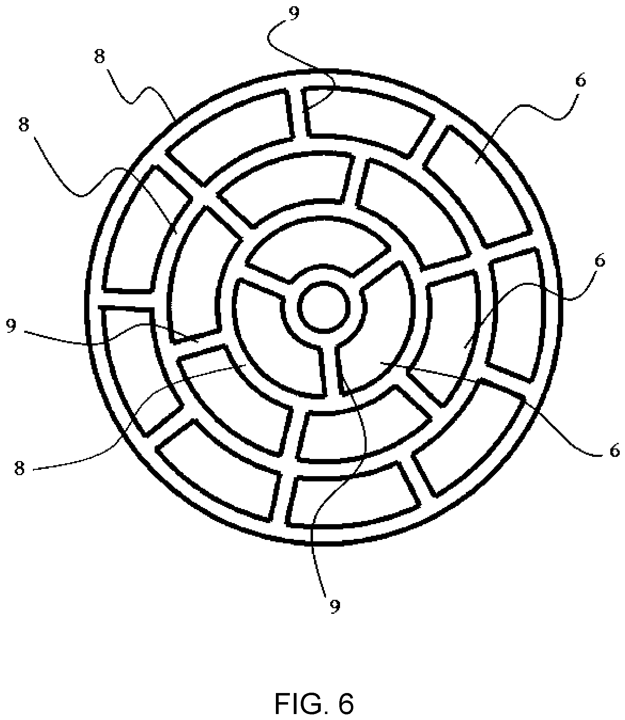

Next, a third embodiment will be described with reference to FIG. 6. FIG. 6 is a schematic view showing the surface of the back plate, in which illustration of the outer edge portion and the bridges connected thereto is omitted. As shown in FIG. 6, the acoustic holes 6, 6, ... are all formed in a substantially rectangular shape. Here, the term "substantially rectangular shape" is used because a pair of long sides are not straight lines but arcs, and therefore the shape is not geometrically defined as a rectangle. In the present embodiment as well, the manner of arranging the acoustic holes 6, 6, ... is the same as in the second embodiment. Two short sides of each acoustic hole 6 are defined by edges of the bridges 9, 9. Two long sides of the acoustic hole 6 are defined by edges of the beams 8, 8. The length of the beams 8, 8 is longer than any of the lengths of the bridges 9, 9.

In the present embodiment, since the acoustic holes 6, 6, ... have a substantially rectangular shape, effects similar to those of the substantially trapezoidal configuration are obtained.

### (Fourth Embodiment)

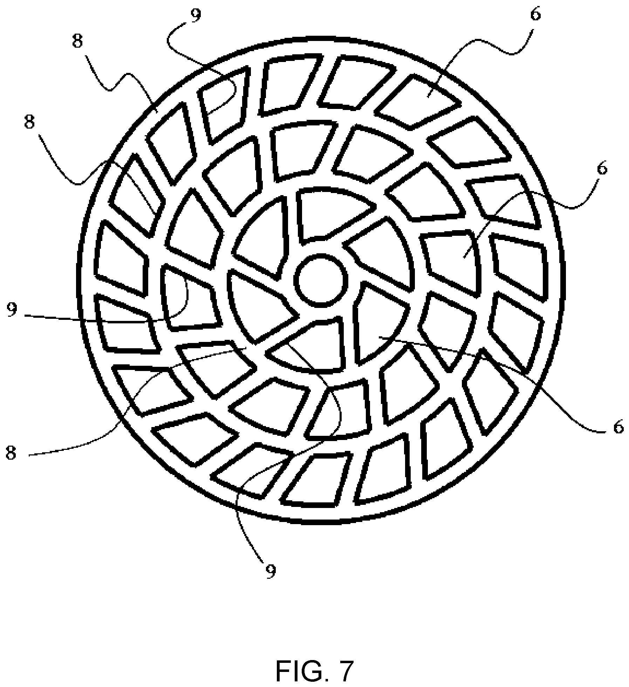

Next, a fourth embodiment will be described with reference to FIG. 7. FIG. 7 is a schematic view showing the surface of the back plate, in which illustration of the outer edge portion and the bridges connected thereto is omitted. As shown in FIG. 7, the acoustic holes 6, 6, ... are all formed in a substantially quadrangular shape in which one pair of diagonal corners are acute angles and the other pair are obtuse angles. In the present embodiment as well, the manner of arranging the acoustic holes 6, 6, ... is the same as in the second embodiment. The four corners of each acoustic hole 6 are formed by intersections of edges of the beams 8 and edges of the bridges 9, and one pair of diagonal corners are acute angles while the other pair of diagonal corners are obtuse angles.

In the present embodiment, since the acoustic holes 6, 6, ... have a substantially quadrangular shape in which one pair of diagonal corners are acute angles and the other pair are obtuse angles, extension lines of the bridges 9 do not intersect at the center of the back plate, thereby allowing the direction of stress to be dispersed when some external force acts on the back plate.

Although the present disclosure has been described with reference to the embodiments, the present disclosure is not limited to the embodiments or structures described above. The present disclosure includes various modifications and variations within the scope of equivalents. In addition, various combinations and configurations, as well as other combinations and forms including only positional relationships, additional elements, or fewer elements, are also intended to fall within the scope and spirit of the present disclosure.

In the above-described embodiments, the structure of the diaphragm may be appropriately modified. For example, the diaphragm is not limited to one whose peripheral edge is fixed and may instead be supported at several points or supported at its center by a central pillar.

In the above-described embodiments, the MEMS transducer illustrated is of the back chamber type; however, it may also be of the front chamber type.

In the above-described embodiments, the MEMS transducer illustrated is of a single-membrane type; however, it may also be of the double membrane type. In that case, the back plate is interposed between the two membranes. The MEMS transducer may also be of a dual membrane type, in which case a plurality of back plates are arranged so as to face the respective membranes.

Furthermore, in the above-described embodiments, the MEMS transducer illustrated do not incorporate a signal processing circuit; however, input capacitors, an amplifier, a charge pump, a quantization circuit, and the like may be integrated together on the same substrate.

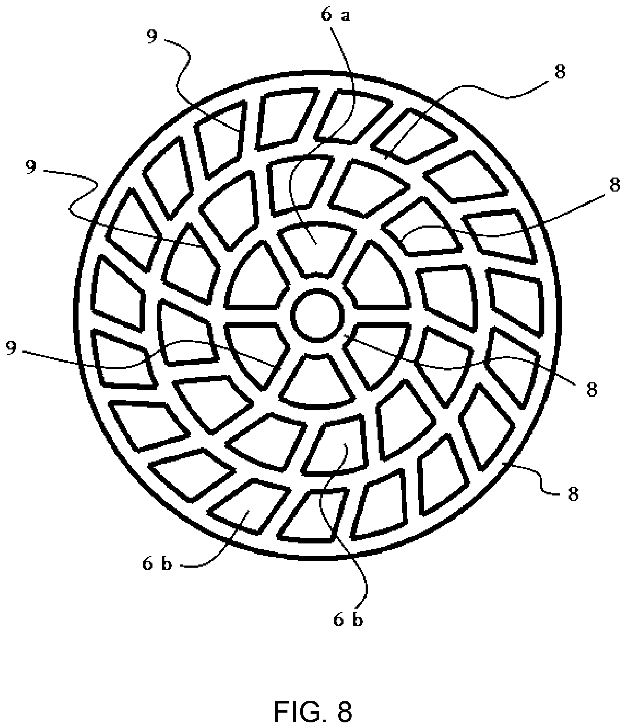

The above-described embodiments may also be combined as appropriate. By combining the second embodiment and the fourth embodiment, as shown in FIG. 8, substantially trapezoidal acoustic holes 6a and acoustic holes 6b having one pair of diagonal acute corners and the other pair of obtuse angles may coexist.

### [Description of Reference Numerals]

1: Substrate, 2: Diaphragm, 3: Insulating film, 4: Back plate, 5: Fixed electrode, 6: Acoustic hole

## Claims

1. A back plate of a MEMS microphone, comprising:
a plurality of beams arranged concentrically;
an outer edge portion surrounding all of the plurality of beams; and
a plurality of bridges connecting an outermost beam among the plurality of beams to the outer edge portion and connecting adjacent beams,
wherein acoustic holes defined by the outer edge portion, the plurality of beams, and the plurality of bridges have a substantially quadrangular shape, and
wherein the acoustic holes all have substantially the same opening area.

2. The back plate of a MEMS microphone according to claim 1,
wherein the acoustic holes have a substantially trapezoidal shape, and an upper base of the substantially trapezoidal shape is defined by an edge of the beam closer to the center.

3. The back plate of a MEMS microphone according to claim 1,
wherein the acoustic holes have a substantially rectangular shape, and a length of a side defined by an edge of the beam is longer than a length of a side defined by an edge of the bridge.

4. The back plate of a MEMS microphone according to claim 1,
wherein the acoustic holes have four corners defined by edges of the beams and edges of the bridges, and
one pair of diagonal corners of the four corners are acute angles, and the other pair of diagonal corners are obtuse angles.

5. The back plate of a MEMS microphone according to claim 1,
wherein the acoustic holes include a mixture of substantially trapezoidal acoustic holes in which an upper base is defined by an edge of the beam closer to the center, and
acoustic holes having four corners defined by edges of the beams and edges of the bridges, one pair of diagonal corners of the four corners being acute angles and the other pair of diagonal corners being obtuse angles.
